# EUROPEAN PATENT SPECIFICATION

(11) **EP 2 367 964 B1**
(45) Date of publication and mention of the grant of the patent: **30.04.2014**
(21) Application number: 09798951.1
(22) Date of filing: 20.11.2009
(51) Int. Cl.: C03C 3/06, C03B 19/06, C23C 16/46

(54) **REACTION CHAMBER OF AN EPITAXIAL REACTOR**
REAKTIONSKAMMER EINES EPITAXIALEN REAKTORS
CHAMBRE DE RÉACTION D'UN RÉACTEUR ÉPITAXIAL

(30) Priority: 24.11.2008 IT MI20082092
(43) Date of publication of application: 28.09.2011
(73) Proprietor: LPE S.p.A., 20021 Baranzate (MI) (IT)
(72) Inventor: PRETI, Mario, I-20025 Legnano (MI) (IT)
(74) Representative: De Ros, Alberto
(86) International application number: PCT/IB2009/007505
(87) International publication number: WO 2010/058269

(56) References cited:
- WO-A1-91/17839
- DE-A1-102006 052 512
- US-A1- 2008 008 566
- KANT C H ET AL: "Infrared Heating with Opaque Quartz Reflector Technology", CONFERENCE RECORD OF THE 2006 IEEE 4TH WORLD CONFERENCE ON PHOTOVOLTAIC ENERGY CONVERSION (IEEE CAT. NO.06CH37747), IEEE, 1 May 2006 (2006-05-01), pages 1249-1252, XP031007540, ISBN: 978-1-4244-0016-4

## Description

The present invention relates to a reaction chamber of an epitaxial reactor.

Epitaxial reactors are machines designed for depositing monocrystalline or polycrystalline layers of a material smoothly and evenly on substrates; the substrates thus treated are then used for manufacturing electric devices (e.g. solar cells), electronic devices (e.g. MOSFETs and LEDs) and microelectronic devices (e.g. integrated circuits).

The substrates consist of very thin discs (their thickness being typically in the range of 100 µm to 1'500 µm) having a widely variable diameter (typically between 1 "=25mm and 18"=450mm), and they can be made, for example, of silicon [SI], silicon carbide [SiC], germanium [Ge], gallium arsenide [GaAs], aluminium oxide or sapphire [Al2O3], or gallium nitride [GaN].

The materials deposited are typically conducting or semiconducting materials, e.g. silicon [Si], silicon carbide [SiC], germanium [Ge], gallium arsenide [GaAs], aluminium nitride [AIN], gallium nitride [GaN].

The deposited layer.and the underlying substrate may be made of identical or different materials.

The thickness of the deposited layer may range extensively from a few nanometres to several millimetres; when the thickness of the deposited layer exceeds 1 mm, the deposition process is generally called "bulk growth".

Known epitaxial reactors comprise a reaction chamber generally consisting essentially of a hollow quartz piece; said hollow quartz piece comprises a quartz piece section having the shape of a cylinder or a prism or a cone or a pyramid and an axial through hole; said quartz piece section is adapted to define, according to two of three directions, a reaction and deposition zone and to house at least one susceptor to be heated inside the axial through hole; the susceptor is used for supporting, and often also for heating, the substrates.

There are many types of reactors; depending on the type, the chamber may be arranged vertically or horizontally (seldom obliquely); depending on the type, the susceptor may have the shape of a disc, prism, cylinder, pyramid or cone, and may be either solid or hollow; depending on the type, the susceptor may be heated by means of resistors, inductors, lamps (seldom by internal burners); depending on the type, the reactor may be a "cold-wall" or "hot-wall" reactor (these terms referring to the walls that define the space where reaction and deposition take place).

Processes are carried out in epitaxial reactors at high temperatures, i.e. ranging from several hundreds of Celsius degrees to a few thousands of Celsius degrees (e.g. deposition of polycrystalline silicon typically occurs at temperatures between 450°C and 800°C, deposition of monocrystalline silicon on silicon substrates typically occurs at temperatures between 850°C and 1'250°C, deposition of monocrystalline silicon carbide on silicon substrates typically occurs at temperatures between 1'200°C and 1'400°C, deposition of monocrystalline silicon carbide on silicon carbide substrates typically occurs at temperatures between 1'500°C and 1'700°C for the so-called "epitaxial growth" and at temperatures between 1'900°C and 2'400°C for the so-called "bulk growth"), and they require much energy (tens of KW) for heating; therefore, it is important to avoid that the generated thermal energy is dissipated into the environment.

To this end, it has been a common practice for many decades to apply a thin (less than 100µm) layer of gold-based material to the outer surface of the reaction chamber of epitaxial reactors; such gold layer is obtained through a certain number of painting and drying cycles (it is not easy to obtain a smooth, even and non-porous layer), and it reflects well the infrared radiations emitted by the susceptor.

In those epitaxial reactors where the susceptor is the main element used for heating the substrates (e.g. in induction heating epitaxial reactors), a proper reflection leads to a small difference in temperature between the front side and the back side of the substrates during the growth processes.

One drawback of this solution is that after some time (e.g. a few months) the gold layer detaches from the quartz surface of the reaction chamber - the hotter the quartz surface, the faster the gold layer will detach, also because the thermal expansion of gold is greater than that of quartz; this phenomenon is even more rapid if the reaction chamber is cooled by means of a gas flow (which is quite common), also because of the mechanical action exerted onto the layer by the gas flow; besides, this phenomenon is further promoted by any traces of acids remaining on the surface of the reaction chamber from previous wash cycles.

The detachment of the gold layer leads to an increased electric power consumption by the epitaxial reactor, since a part of the infrared radiations emitted by the susceptor is dissipated into the environment.

Moreover, the irregular and uneven detachment of the gold layer also causes a reduction in the quality of the grown substrates.

It follows that, when said detachment occurs, it is necessary to dismount the reaction chamber from the epitaxial reactor, remove the gold layer (already partly detached) completely, apply a new gold layer and reinstall the reaction chamber into the epitaxial reactor; these operations are costly and time-consuming, and can only be carried out a limited number of times.

The general object of the present invention is to overcome the above-mentioned drawbacks.

This and other objects are achieved through the reaction chamber having the features set out in the appended claims, which are intended as an integral part of the present description.

After having taken into consideration several alternative solutions, the Applicant had the idea of providing the reaction chamber with a reflecting layer made of a material being compatible chemically (with equal or similar chemical properties, e.g. resistance), mechanically (with equal or similar mechanical properties) and thermally (with equal or similar thermal properties, e.g. CTE [Coefficient of Thermal Expansion]) with the material of the reaction chamber.

The Applicant decided to employ a quartz-based reflecting material.

This solution also allows to reach a reflection similar to that of the gold layer used in the prior art (e.g. a reflection of 70-90%, or even more, of the incident radiation).

This approach opens the way to a more flexible, effective and efficient positioning of the reflecting layer in relation to the reaction chamber and susceptor, as will become apparent later on.

In general, the reaction chamber of an epitaxial reactor according to the present invention essentially consists of a hollow quartz piece; said hollow quartz piece comprises a quartz piece section having the shape of a cylinder or a prism or a cone or a pyramid and an axial through hole provided in said quartz piece section; said quartz piece section is adapted to define, according to two of three directions, a reaction and deposition zone and to house at least one susceptor to be heated inside said axial through hole. The chamber according to the present invention further comprises a reflecting layer adapted to reflect back infrared radiations emitted by said susceptor in the wavelength range between 1'000 nm and 10'000 nm, preferably between 1'500 nm and 3'000 nm; said reflecting layer is made of a quartz-based material and is applied to said quartz piece section of said reaction chamber.

Said reflecting layer may be located on the inside and/or on the outside of said quartz piece section.

Said reflecting layer covers entirely said quartz piece section.

Said reflecting layer may be covered partially or entirely by a layer of vitrified quartz.

Said quartz piece section may be provided with another reflecting layer adapted to reflect back infrared radiations emitted by said susceptor; said other reflecting layer is made of a gold-based material.

Said other reflecting layers may cover said quartz piece section in distinct areas.

Said quartz piece section is made of transparent quartz.

The chamber according to the present invention may comprise flanges located at the ends of said hollow quartz piece; said flanges are made of opaque quartz.

The chamber according to the present invention may be adapted to be cooled by means of at least one gas or liquid flow.

According to a further aspect, the present invention also relates to an epitaxial reactor comprising a reaction chamber having any of the features set out above.

The present invention will now be described in detail with reference to the annexed drawings, wherein:
- Fig.1: shows three different views of a first reaction chamber according to the prior art (Fig.1A is a side view, Fig.1B is a top view, Fig.1C is a front view),
- Fig.2: is a side view of a second reaction chamber according to the prior art,
- Fig.3: is a side view of a third reaction chamber according to the prior art,
- Fig.4: is a side view of a fourth reaction chamber according to the prior art,
- Fig.5: shows three different sectional views of a first embodiment of the reaction chamber according to the present invention (Fig.5A is a side view, Fig.5B is a top view, Fig.5C is a front view) - the chamber of Fig.5 corresponds to the chamber of Fig.1 with the addition of technical features in accordance with the present invention, and
- Fig.6: is a sectional side view of a second embodiment of the reaction chamber according to the present invention - the chamber of Fig.6 corresponds to the chamber of Fig.4 with the addition of technical features in accordance with the present invention.

Said description and said drawings are only to be considered as non-limiting explanatory examples; additionally, they are both schematic and simplified.

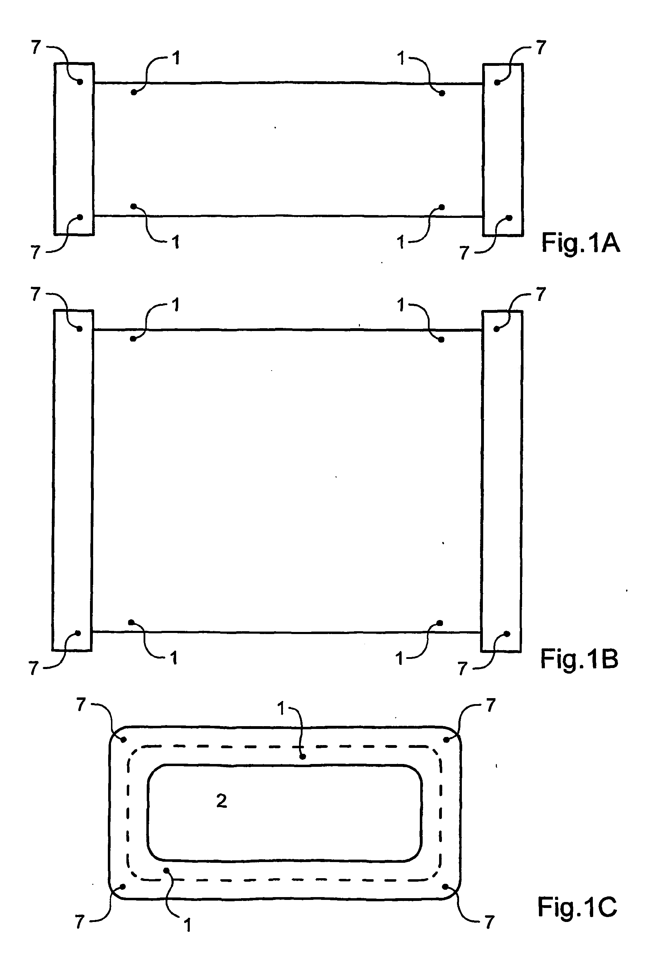

Fig.1 illustrates a reaction chamber of an epitaxial reactor, essentially consisting of a hollow quartz piece; said hollow quartz piece comprises a quartz piece section 1 having the shape of a prism (with rounded longitudinal corners) and an axial through hole 2 provided in the section 1; the section 1 is adapted to define, according to two of three directions (i.e. width and height - see Fig.1C) a reaction and deposition zone 3 (not highlighted in Fig.1) and to house at least one susceptor (not shown in Fig.1) to be heated inside the hole 2; the hole 2 has a rectangular cross-section (with rounded corners) corresponding to the cross-section of the section 1, so that the section 1 is a tube with walls having a substantially constant cross-section.

The chamber of Fig.1 is adapted to be arranged horizontally, to house a disc-shaped susceptor, to be associated with induction heating means, and to be used in a "cold-wall" reactor (wherein the temperature of the hollow quartz piece section 1 does not exceed 400-600°C during the epitaxial growth processes, and is therefore much lower than that of the susceptor).

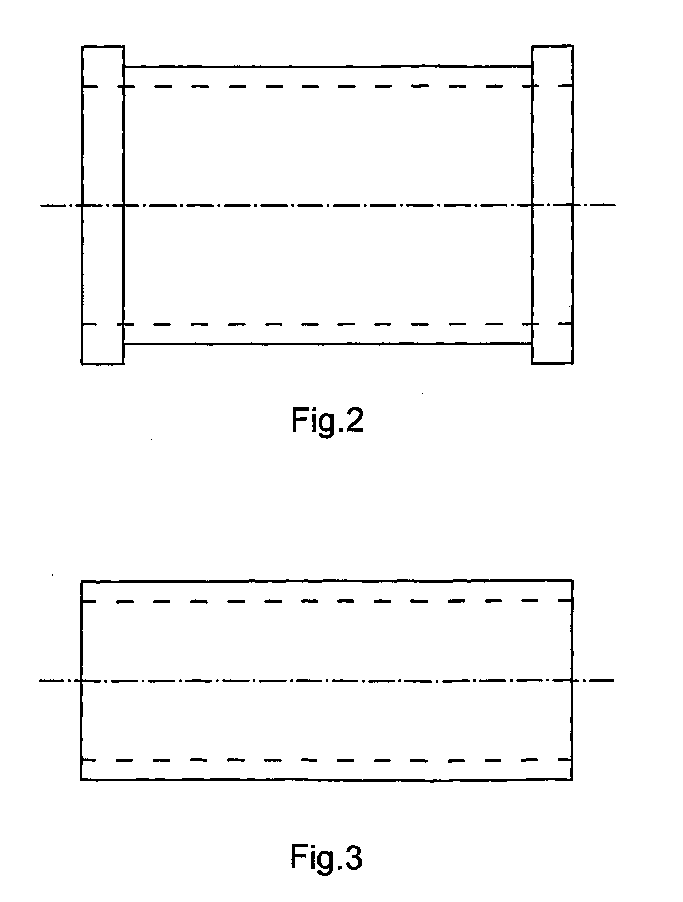

Fig.2 shows a reaction chamber of an epitaxial reactor essentially consisting of a hollow quartz piece; said hollow quartz piece comprises a quartz piece section having the shape of a cylinder and an axial through hole obtained in said section. In this case as well, similarly to the case of Fig.1, the hollow quartz piece section is adapted to define, according to two of three directions, a reaction and deposition zone (having a cylindrical shape) and to house at least one susceptor (having a cylindrical shape) to be heated inside the hole; the hole has a circular cross-section corresponding to the circular cross-section of the quartz piece section, so that the quartz piece section is a tube with walls having a constant cross-section.

The chamber of Fig.2 is adapted to be arranged horizontally, to house a cylindrical susceptor with suitable thermal insulation means, and to be associated with induction heating means.

The chamber of Fig.2 comprises two flanges located at the ends of the hollow quartz piece.

Fig.3 shows a reaction chamber of an epitaxial reactor which is very similar to the one illustrated in Fig.2, the only substantial difference being the absence of any flanges; furthermore, the chamber of Fig.3 is adapted to be arranged vertically, even though it has been drawn horizontally in this figure.

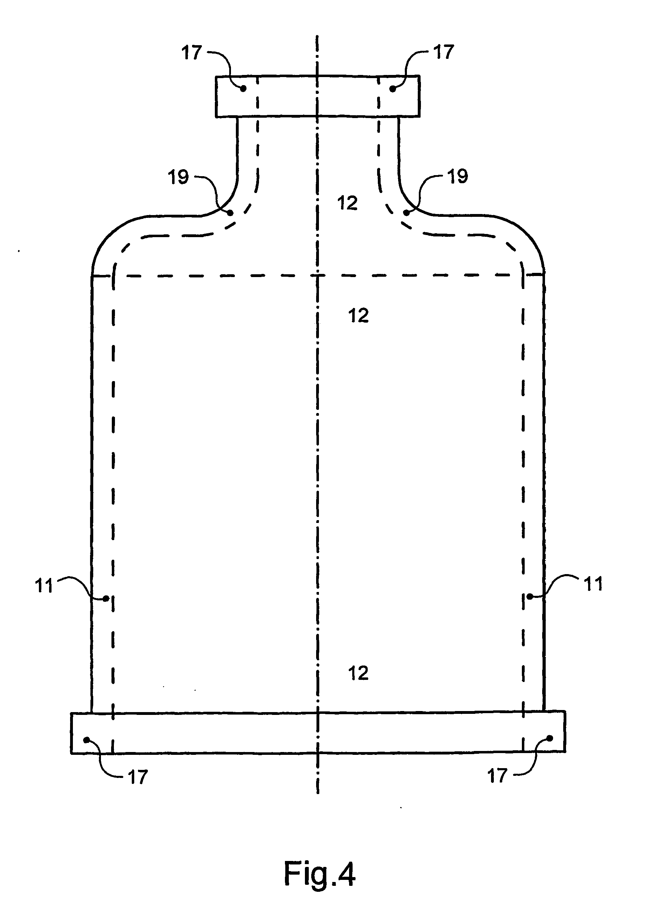

Fig.4 shows a reaction chamber of an epitaxial reactor consisting essentially of a hollow quartz piece; said hollow quartz piece comprises a first quartz piece section 11 having the shape of a cylinder and a second quartz piece section 19 having the shape of an upside-down rounded funnel, joined to the first section 11 (together, the sections 11 and 19 make up a single quartz piece, the horizontal dashed line of Fig.4 being only used for indicating the boundary between the two sections); there is also an axial through hole 12 obtained in the first section 11 (which extends into the second section 19 as well, but with a different cross-section); the first section 11 is adapted to define, according to two of three directions (i.e. two horizontal directions perpendicular to each other) a reaction and deposition zone 13 (not highlighted in Fig.4) and to house at least one susceptor (not shown in Fig.4) to be heated inside the hole 12; the hole 12 has a circular cross-section corresponding to the circular cross-section of the first section 11, so that the first section 11 is a tube with walls having a constant cross-section; the overall shape of the chamber of Fig.4 is called "bell".

The chamber of Fig.4 is adapted to be arranged vertically, to house a susceptor having the shape of a truncated pyramid, to be associated with induction heating means, and to be used in a "cold-wall" reactor (wherein the temperature of the hollow quartz piece section 1 does not exceed 400-600°C during the growth processes, and is therefore much lower than that of the susceptor).

The chamber of Fig.4 comprises two flanges 17 located at the ends of the hollow quartz piece.

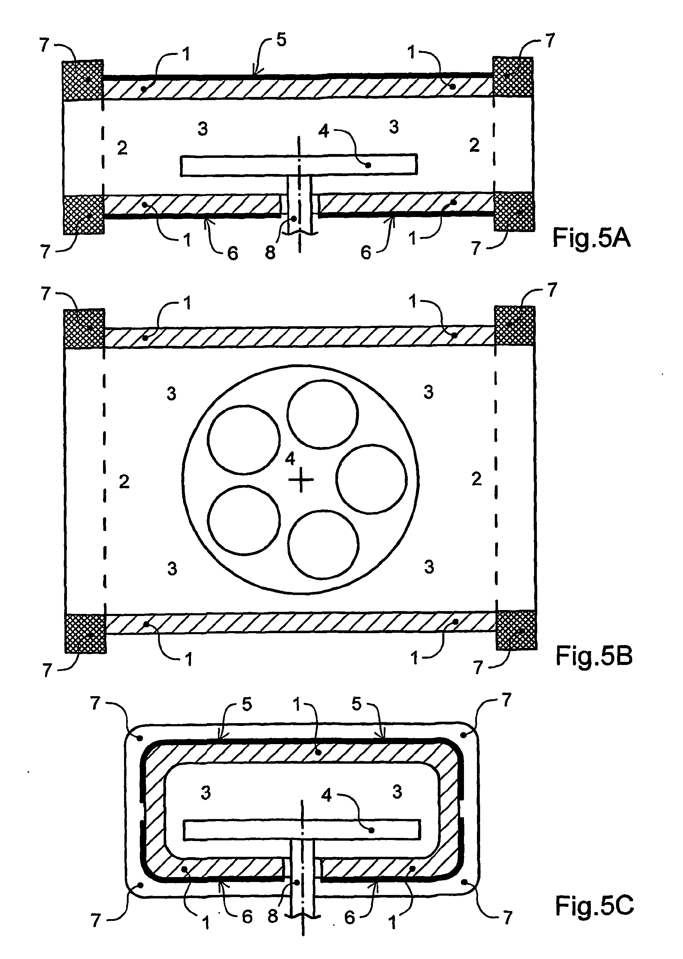

Fig.5 shows a disc-shaped susceptor 4 mounted on a vertical shaft 8 by which it is supported and turned; the susceptor 4 has some moderate recesses (in particular five recesses) on its top face, which recesses are adapted to accommodate substrates to be subjected to epitaxial growth; the shaft 8 passes through a circular hole obtained in one of the chamber walls (sealing means are used which are not shown in this drawing); this figure also clearly shows the reaction and deposition zone 3; it should be noted that neither the susceptor 4 nor the shaft 8 are parts of the chamber.

The chamber of Fig.5 differs from that of Fig.1 in that it comprises a reflecting layer 5 adapted to reflect back infrared radiations emitted by the susceptor 4 in the wavelength range between 1'000 nm and 10'000 nm, preferably between 1'500 nm and 3'000 nm; the reflecting layer 5 is made of a quartz-based material and is applied to the section 1.

The thickness of the reflecting layer 5 is typically in the range of 0.5 mm to 1.5 mm, being preferably about 1 mm.

The reflecting layer 5 can be obtained through the following process:
- a semiliquid slurry having a high content (e.g. more than 80% and less than 95%) of dispersed amorphous quartz particles (the dispersion liquid may be water or, for example, alcohol) is applied to the transparent quartz reaction chamber, and
- the slurry thus applied is dried, and
- the dried slurry is hot sintered.

In this manner it is possible to obtain a layer which is capable of reflecting, on average, 70-90% (or even more) of the infrared radiations (within the above-mentioned wavelength ranges and per unit of covered surface) that hit the layer; it should be pointed out that the layer's reflection degree is strongly affected not only by the process used for obtaining the reflecting layer, but also by how the process is carried out (e.g. with reference to the process described above, by the manner in which the mixture is applied).

In the example of Fig.5, the reflecting layer 5 is located on the outside of the section 1 and covers it for slightly less than 50%, in particular at the upper half; alternatively, the coverage may be total or almost total, e.g. 75-95% (or even more).

It is important that the reflecting layer covers the quartz section in areas located near the susceptor. In the frequent case wherein the susceptor is arranged in a central zone of the quartz section, it is important that the reflecting layer covers the quartz section in one or more central areas. In the case of the example of Fig. 5, the reflecting layer may, for instance, be arranged vertically above and/or under the susceptor 4; in addition, areas along the sides of the susceptor 4 may be covered with a reflecting layer as well; of course, extending the reflecting layer beyond the above specifications can only be advantageous for the purposes of the present invention.

In the example of Fig.5, the section 1 is also provided with another (optional but advantageous) reflecting layer 6 adapted to reflect back infrared radiations emitted by the susceptor 4; the reflecting layer 6 is made of a gold-based material, in particular a gold paint; the thickness of the reflecting layer 6 is less than 100 µm.

In the example of Fig.5, the reflecting layer 6 is located on the outside of the section 1 and covers it for slightly less than 50%, in particular at the lower half.

In the example of Fig.5, the layers 5 and 6 never overlap, i.e. they cover the quartz piece section in distinct areas.

Although it may appear from this figure that there is an uncovered area of the outside surface of the section 1, this is only because the drawing is a diagrammatic one; in fact, according to the present invention it is preferable that the entire surface of the quartz piece section is covered with a quartz and/or gold reflecting layer, in order to limit as much as possible the dissipation of thermal energy into the environment; therefore, it could be necessary to leave some small windows uncovered, e.g. for reading temperature values with a pyrometer.

As far as cooling is concerned, the lower half of the chamber of Fig.5 is cooled by means of a liquid flow, typically water (in particular, it is immersed into a tub full of water), whereas the upper half is cooled by means of a gas flow, typically air; of course, different arrangements and combinations are possible as well.

The reflecting layer 5 may be covered partially or entirely by a layer of vitrified quartz; the thickness of said vitrified layer may typically be in the range of 0.5 mm to 1.5 mm.

The reflecting quartz layer and the overlapping vitrified quartz layer can be obtained through the following process:
- a semiliquid slurry having a high content (e.g. more than 80% and less than 95%) of dispersed amorphous quartz particles (the dispersion liquid may be water or, for example, alcohol) is applied to the transparent quartz reaction chamber, and
- the slurry thus applied is dried, and
- the dried slurry is hot sintered, and
- the sintered slurry is vitrified superficially to a predetermined depth only, e.g. through a flame or a laser beam;
of course, enough slurry will have to be applied as necessary for making both the reflecting quartz layer and the vitrified quartz layer.

The vitrified layer protects the underlying reflecting layer from both the chemical and mechanical points of view; it follows that, when a very good quality layer is made, it will also be possible to locate the reflecting layer on the inside of the hollow quartz piece section, thus further limiting the amount of thermal energy dissipated into the environment.

The chamber of Fig.5 also comprises two flanges 7 located at the ends of the hollow quartz piece, in particular of the section 1.

The section 1 is made of transparent quartz, in particular quartz being transparent to visible light as well as to infrared light.

The flanges 7 are made of opaque quartz, in particular quartz being opaque to visible light as well as to infrared light (i.e. not allowing it to pass through, thus partly reflecting it and partly absorbing it).

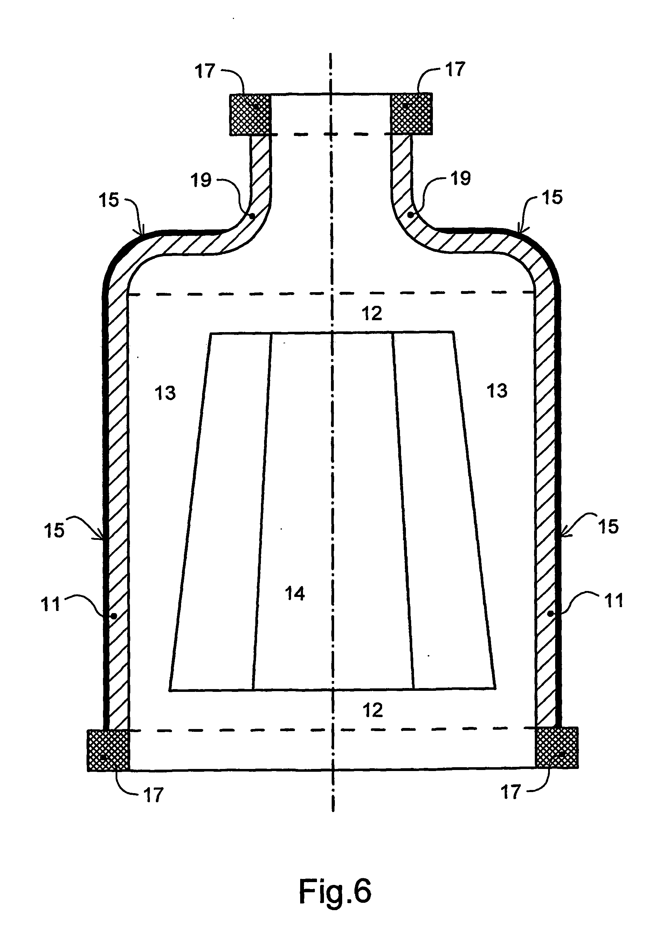

Fig.6 shows a susceptor 14 having the shape of a truncated pyramid; the susceptor 14 is supported and turned by suitable means not shown in this drawing; the susceptor 14 has some moderate recesses (not shown) on its side faces, which recesses are adapted to accommodate substrates; this figure also clearly shows the reaction and deposition zone 13; finally, it should be noted that the susceptor 14 is not a part of the chamber.

The chamber of Fig.6 differs from that of Fig.4 in that it comprises a reflecting layer 15 adapted to reflect back infrared radiations emitted by the susceptor 14 in the wavelength range between 1'000 nm and 10'000 nm, preferably between 1'500 nm and 3'000 nm; the reflecting layer 15 is made of a quartz-based material and is applied to the section 11; the reflecting layer 15 partially extends over the section 19 as well.

The layer 15 of Fig.6 has the same features as the layer 5 of Fig.5, and can be obtained in the same manner.

In the example of Fig.6, the reflecting layer 15 is located on the outside of the section 11 and covers it entirely; furthermore, it also extends partially over the section 19; alternatively, the coverage may be almost total, e.g. 75-95% (or even more) of the quartz section (11).

It is important that the reflecting layer covers the quartz section in areas located near the susceptor. In the frequent case wherein the susceptor is arranged in a central zone of the quartz section, it is important that the reflecting layer covers the quartz section in one or more central areas. In the case of the example of Fig. 6, the reflecting layer may, for instance, be arranged horizontally beside the susceptor 14 for all or almost all (e.g. 80-90%) the vertical extension thereof; of course, extending the reflecting layer beyond the above specifications can only be advantageous for the purposes of the present invention.

As far as cooling is concerned, the chamber of Fig.6 is only cooled by a gas flow, typically air.

The chamber of Fig.6 also comprises two flanges 17 at the ends of the hollow quartz piece, in particular at the lower end of the section 11 and at the upper end of the section 19.

The section 11 and the section 19 are made of transparent quartz, in particular quartz being transparent to visible light as well as to infrared light.

The flanges 17 are made of opaque quartz, in particular quartz being opaque to visible light as well as to infrared light.

In the two embodiments described herein with reference to Fig.5 and Fig.6, the reflecting quartz layer is applied to a section of the hollow quartz piece consisting essentially of the reaction chamber. As an alternative or in addition, according to the present invention the reflecting quartz layer may be applied to a quartz component of the chamber for the purpose of reflecting back infrared radiations emitted by the susceptor; for example, in the case of Fig.5 a quartz component consisting of a holed disc having a reflecting quartz layer could be provided inside the zone 3 under the susceptor 4.

It is apparent from the above description that the reflecting layer may be positioned in many different ways.

Mainly, reaction chambers like those described herein are advantageously used and comprised in epitaxial reactors.

## Claims

1. Reaction chamber of an epitaxial reactor consisting of a hollow quartz piece and optionally flanges (7; 17) located at the ends of said hollow quartz piece**,** wherein said hollow quartz piece consists of a quartz piece section (1; 11) having the shape of a cylinder or a prism or a cone or a pyramid and optionally, ioined thereto, another hollow quartz piece section (19) having the shape of an upside-down rounded funnel**,** and an axial through hole (2; 12) provided in said quartz piece section (1; 11) and said another quartz piece section (19), wherein said quartz piece section (1; 11) is adapted to define, according to two of three directions, the reaction and deposition zone (3; 13) of the reaction chamber and to house at least one susceptor (4; 14) to be heated inside said axial through hole (2; 12), said chamber being **characterized in that** it comprises a reflecting layer (5; 15) adapted to reflect back infrared radiations emitted by said susceptor (4; 14) in the wavelength range between 1'000 nm and 10'000 nm, preferably between 1'500 nm and 3'000 nm, wherein said reflecting layer (5; 15) is made of a quartz-based material, and wherein said reflecting layer (5; 15) is applied to said quartz piece section (1; 11),
wherein said quartz piece section (1; 11) is made of transparent quartz,
wherein said reflecting layer (5; 15) covers entirely said quartz piece section (1; 11),
wherein said reflecting layer (5; 15) is obtained from a semiliquid slurry having a content of dispersed amorphous quartz particles

2. Reaction chamber according to claim 1, wherein said reflecting layer (5; 15) is located on the inside and/or on the outside of said quartz piece section (1; 11).

3. Reaction chamber according to claim 1 or 2, wherein said reflecting layer is covered partially or entirely by a layer of vitrified quartz.

4. Reaction chamber according to any of the preceding claims from 1 to 3, **characterized in that** said quartz piece section (1) is provided with another reflecting layer (6) adapted to reflect back infrared radiations emitted by said susceptor (4), wherein said other reflecting layer (6) is made of a gold-based material.

5. Reaction chamber according to claim 4, wherein said other reflecting layers (6) cover said quartz piece section (1) in distinct areas.

6. Reaction chamber according to any of the preceding claims from 1 to 5, wherein said flanges (7; 17) are made of opaque quartz.

7. Reaction chamber according to any of the preceding claims from 1 to 6, **characterized by** being adapted to be cooled by means of at least one gas or liquid flow.

8. Epitaxial reactor **characterized in that** it comprises a reaction chamber according to any of the preceding claims from 1 to 7.

## Patentansprüche

1. Reaktionskammer für einen epitaxialen Reaktor, aufweisend ein hohles Quarzbauteil und optionale Flansche (7, 17) an den Enden des hohlen Quarzbauteils, wobei das hohle Quarzbauteil einen Quarzbauteilabschnitt (1, 11), der die Form eines Zylinders oder eines Prismas oder eines Kegels oder einer Pyramide aufweist, und optional hiermit verbunden einen weiteren Quarzbauteilabschnitt (19) in der Form eines umgekehrten, abgerundeten Trichters, und ein axiales Durchgangsloch (2, 12) in dem Quarzbauteilabschnitt (1, 11) und dem weiteren Quarzbauteilabschnitt (19) aufweist, wobei der Quarzbauteilabschnitt (1, 11) derart ausgelegt ist, die Reaktions- und Ablagerungszone (3, 13) der Reaktionskammer in zwei oder drei Richtungen festzulegen und zumindest einen Suszeptor (4,14) aufzunehmen, der in der axialen Durchgangsbohrung (2, 12) erwärmt werden soll,
**dadurch gekennzeichnet,**
**dass** die Reaktionskammer eine reflektierende Schicht (5, 15) aufweist, die dazu ausgebildet ist, infrarote Strahlung, die vom Suszeptor im Wellenlängenbereich zwischen 1.000 nm und 10.000 nm, bevorzugt zwischen 1.500 nm und 3.000 nm, emittiert wird, zurück zu reflektieren, wobei die reflektierende Schicht (5, 15) aus einem auf Quarz basierenden Material hergestellt ist, und wobei die reflektierende Schicht (5, 15) auf den Quarzbauteilabschnitt (1, 11) aufgetragen ist,
wobei weiter der Quarzbauteilabschnitt (1, 11) aus transparentem Quarz hergestellt ist, und die reflektierende Schicht (5, 15) den Quarzbauteilabschnitt (1, 11) vollständig bedeckt, und die reflektierende Schicht (5,15) aus einer halbflüssigen Aufschlämmung erhalten wurde, die dispergierte amorphe Quarzpartikel enthält.

2. Reaktionskammer nach Anspruch 1, **dadurch gekennzeichnet, dass** die reflektierende Schicht (5, 15) auf der Innenseite und/oder auf der Außenseite des Quarzbauteilabschnitts (1, 11) angeordnet ist.

3. Reaktionskammer nach Anspruch 1 oder 2, **dadurch gekennzeichnet, dass** die reflektierende Schicht (5, 15) teilweise oder vollständig mit einer Schicht von verglastem Quarz bedeckt ist.

4. Reaktionskammer nach einem der voranstehenden Ansprüche 1 bis 3, **dadurch gekennzeichnet, dass** der Quarzbauteilabschnitt (11) mit einer weiteren reflektierenden Schicht (6) versehen ist, die dazu ausgelegt ist, infrarotes Licht, das vom Suszeptor emittiert wird, zurück zu reflektieren, wobei die weitere reflektierende Schicht (6) aus einem auf Gold basierenden Material hergestellt ist.

5. Reaktionskammer nach Anspruch 4, **dadurch gekennzeichnet, dass** die weitere reflektierende Schicht (6) den Quarzbauteilabschnitt (1, 11) in unterschiedlichen Bereichen bedeckt.

6. Reaktionskammer nach einem der voranstehenden Ansprüche 1 bis 5, **dadurch gekennzeichnet, dass** die Flansche (7, 17) aus opakem Quarz hergestellt sind.

7. Reaktionskammer nach einem der voranstehenden Ansprüche 1 bis 6, **dadurch gekennzeichnet, dass** die Reaktionskammer dazu ausgelegt ist, durch zumindest einen Gas- oder Flüssigkeitsstrom gekühlt zu werden.

8. Epitaxialer Reaktor, **dadurch gekennzeichnet, dass** er eine Reaktionskammer nach einem der voranstehenden Ansprüche 1 bis 7 aufweist.

## Revendications

1. Chambre de réaction d'un réacteur épitaxial constituée d'une pièce de quartz creuse et facultativement de brides (7 ; 17) situées aux extrémités de ladite pièce de quartz creuse, dans laquelle ladite pièce de quartz creuse est constituée d'une section de pièce de quartz (1 ; 11) présentant la forme d'un cylindre ou d'un prisme ou d'un cône ou d'une pyramide et facultativement, jointe à celle-ci, une autre section de pièce de quartz creuse (19) présentant la forme d'un entonnoir arrondi à l'envers, et d'un trou débouchant axial (2 ; 12) prévu dans ladite section de pièce de quartz (1 ; 11) et ladite autre section de pièce de quartz (19), dans laquelle ladite section de pièce de quartz (1 ; 11) est adaptée pour définir, selon deux de trois directions, la zone de réaction et de dépôt (3 ; 13) de la chambre de réaction et pour loger au moins un suscepteur (4 ; 14) destiné à être chauffé à l'intérieur dudit trou débouchant axial (2 ; 12), ladite chambre étant **caractérisée en ce qu'**elle comprend une couche réfléchissante (5 ; 15) adaptée pour réfléchir des rayonnements infrarouges émis par ledit suscepteur (4 ; 14) dans la plage de longueurs d'onde entre 1000 nm et 10000 nm, de préférence entre 1500 nm et 3000 nm, dans laquelle ladite couche réfléchissante (5 ; 15) est faite d'un matériau à base de quartz, et dans laquelle ladite couche réfléchissante (5 ; 15) est appliquée sur ladite section de pièce de quartz (1 ; 11),
dans laquelle ladite section de pièce de quartz (1 ; 11) est faite de quartz transparent,
dans laquelle ladite couche réfléchissante (5 ; 15) couvre entièrement ladite section de pièce de quartz (1 ; 11),
dans laquelle ladite couche réfléchissante (5 ; 15) est obtenue à partir d'une boue semi-liquide comportant une teneur en particules de quartz amorphes dispersées.

2. Chambre de réaction selon la revendication 1, dans laquelle ladite couche réfléchissante (5 ; 15) est située sur l'intérieur et/ou sur l'extérieur de ladite section de pièce de quartz (1 ; 11).

3. Chambre de réaction selon la revendication 1 ou 2, dans laquelle ladite couche réfléchissante est couverte partiellement ou entièrement par une couche de quartz vitrifié.

4. Chambre de réaction selon une quelconque des revendications précédentes 1 à 3, **caractérisée en ce que** ladite section de pièce de quartz (1) est pourvue d'une autre couche réfléchissante (6) adaptée pour réfléchir des rayonnements infrarouges émis par ledit suscepteur (4), dans laquelle ladite autre couche réfléchissante (6) est faite d'un matériau à base d'or.

5. Chambre de réaction selon la revendication 4, dans laquelle ladite autre couche réfléchissante (6) couvre ladite section de pièce de quartz (1) dans des zones distinctes.

6. Chambre de réaction selon une quelconque des revendications précédentes 1 à 5, dans laquelle lesdites brides (7 ; 17) sont faites de quartz opaque.

7. Chambre de réaction selon une quelconque des revendications précédentes 1 à 6, **caractérisée en ce qu'**elle est adaptée pour être refroidie au moyen d'au moins un écoulement de gaz ou liquide.

8. Réacteur épitaxial, **caractérisé en ce qu'**il comprend une chambre de réaction selon une quelconque des revendications précédentes 1 à 7.
